# EUROPÄISCHE PATENTANMELDUNG

(11) **EP 1 626 286 A1**
(43) Veröffentlichungstag der Anmeldung: **15.02.2006**
(21) Anmeldenummer: 05015405.3
(22) Anmeldetag: 15.07.2005
(51) Int. Cl.: G01R 33/34

(54) **System von supraleitenden Rf-Resonatoren für die magnetische Resonanz**

(30) Priorität: 23.07.2004 DE 102004035851
(71) Anmelder: Bruker BioSpin AG, 8117 Fällanden (CH)
(72) Erfinder: Freytag, Nicolas, 8122 Binz (CH)
(74) Vertreter: Kohler Schmid Möbus

(57) **Zusammenfassung**

Ein Resonatorsystem zur Erzeugung eines Hochfrequenz (=HF)-Magnetfelds im Untersuchungsvolumen einer Magnetresonanz (=MR) Anordnung, das eine Anzahl *N* von Einzelresonatoren (2) umfasst, die das Untersuchungsvolumen umgeben und welche jeweils auf ebenen, dielektrischen Substraten (1) aufgebracht und um eine z-Achse angeordnet sind, wobei die Einzelresonatoren (2) Fenster (8) aufweisen, durch die hindurch im Einzelbetrieb der Einzelresonatoren (2) im Untersuchungsvolumen jeweils ein Einzel-HF-Feld und im Zusammenwirken der Einzelresonatoren (2) im Untersuchungsvolumen ein Nutz-HF-Feld (7) und weit außerhalb des Resonatorsystems asymptotisch ein Fern-HF-Feld (6) erzeugt werden, wobei die räumliche Verteilung des Nutz-HF-Felds (7) zu einer ersten Ebene A, die die z-Achse enthält, und die des asymptotischen Fern-HF-Felds (6) zu einer zweiten Ebene B, die die z-Achse enthält, jeweils im Wesentlichen spiegelsymmetrisch ist, und im Untersuchungsvolumen das Nutz-HF-Feld (7) im Wesentlichen parallel zur ersten Ebene A verläuft, wobei die Anzahl der Einzelresonatoren (2) *N* > 4 beträgt, und wobei im Betrieb des Resonatorsystems zu mindestens einem Zeitpunkt die Substratebene mindestens eines Einzelresonators (2) einen Winkel größer als 40° und mindestens eines weiteren Einzelresonators (2) einen Winkel kleiner als 40° mit der Richtung des Nutz-HF-Felds (7) im Untersuchungsvolumen einschließt, ist dadurch gekennzeichnet, dass die erste Ebene A gegenüber der zweiten Ebene B nicht oder um weniger als 360°/(N+1) um die z-Achse verdreht ist.

Das erfindungsgemäße Resonatorsystem realisiert mit konstruktiv einfachen Mitteln ein Resonatorsystem mit einer verbesserten Feldhomogenität bei voller Quadraturtauglichkeit, hoher Güte und großer Effizienz.

## Beschreibung

Die Erfindung betrifft ein Resonatorsystem zur Erzeugung eines Hochfrequenz (=HF)-Magnetfelds im Untersuchungsvolumen einer Magnetresonanz (=MR) Anordnung, das eine Anzahl N von Einzelresonatoren umfasst, die das Untersuchungsvolumen umgeben und welche jeweils auf ebenen, dielektrischen Substraten aufgebracht und um eine z-Achse angeordnet sind, wobei die Einzelresonatoren Fenster aufweisen, durch die hindurch im Einzelbetrieb der Einzelresonatoren im Untersuchungsvolumen jeweils ein Einzel-HF-Feld und im Zusammenwirken der Einzelresonatoren im Untersuchungsvolumen ein Nutz-HF-Feld und weit außerhalb des Resonatorsystems asymptotisch ein Fern-HF-Feld erzeugt werden, wobei die räumliche Verteilung des Nutz-HF-Felds zu einer ersten Ebene A, die die z-Achse enthält, und die des asymptotischen Fern-HF-Felds zu einer zweiten Ebene B, die die z-Achse enthält, jeweils im Wesentlichen spiegelsymmetrisch ist, und im Untersuchungsvolumen das Nutzfeld im Wesentlichen parallel zur ersten Ebene verläuft, wobei die Anzahl der Einzelresonatoren *N >* 4 beträgt, und wobei im Betrieb des Resonatorsystems zu mindestens einem Zeitpunkt die Substratebene mindestens eines Einzelresonators einen Winkel größer als 40° und mindestens eines weiteren Einzelresonators einen Winkel kleiner als 40° mit der Richtung des Nutz-HF-Feldes im Untersuchungsvolumen einschließt.

Ein gattungsgemäßes Resonatorsystem ist aus Referenz [9] bekannt.

NMR ist eine sehr aussagekräftige und genaue Methode zur Strukturanalyse chemischer Verbindungen. Zur Einstrahlung der HF-Impulse in die Probe oder auch zur Detektion der hochfrequenten elektromagnetischen Felder aus der Probe werden HF-Resonator-Systeme eingesetzt. Ein HF-Resonatorsystem besteht aus einem oder mehreren HF-Resonatoren, die für die NMR-Messung in unmittelbarer Nähe der Probe angeordnet sind. Dank der Verwendung von gekühlten und insbesondere supraleitenden Hochfrequenzresonatoren, ist es möglich, Verluste im Resonator sehr klein zu halten, und damit die Empfindlichkeit wesentlich zu steigern, so dass eine möglichst hohe Empfangs-Empfindlichkeit, d.h. ein möglichst hohes S/N-Verhältnis realisiert werden kann.

Als Supraleiter eignen sich gegenwärtig HTS-Materialien am besten. Diese besitzen eine hohe Sprungtemperatur und sind, verglichen mit anderen Supraleitern, sehr unempfindlich gegenüber statischen magnetischen Feldern. Erreicht werden diese guten Eigenschaften, insbesondere die hohen kritischen Stromdichten, aber nur dann, wenn der Supraleiter aus sehr dünnen, epitaktischen Schichten besteht, die auf orientierten einkristallinen Substraten aufgebaut sind, wobei diese Substrate normalerweise nur als ebene Plättchen zur Verfügung stehen. Das hat zur Folge, dass die geometrische Form der Einzelresonatoren nicht beliebig sein darf sondern aus ebenen Plättchen aufgebaut werden muss, was natürlich die möglichen geometrischen Ausführungsformen stark beschränkt.

Solche Anordnungen sind z.B. aus Referenzen [1] - [9] bekannt. Die wesentlichen Probleme, die bei der Verwendung supraleitender Empfangsresonatoren auftreten, sind einerseits die vom Supraleiter erzeugte statische Magnetisierung, welche Feldinhomogenitäten erzeugen kann und das Erreichen schmaler Linien in der hochauflösenden NMR sehr stark erschwert, und anderseits der beschränkte kritische Strom im Supraleiter, der den maximalen Spulenstrom des Sendepulses begrenzt und dadurch das Erreichen kurzer Pulsbreiten für einen vorgegebenen NMR-Flipwinkel erschwert oder verhindert.

Zur effizienteren Anregung des Spinsystems ist es bekannt, Resonatorsysteme in Quadratur zu betreiben. Dies ist jedoch nur bei Resonatorsystemen mit mehreren Resonatoren möglich. Dazu werden räumliche Drehfelder erzeugt, d.h. der zweite Resonator wird mit Sendepulsen angeregt, dessen Hochfrequenzphase um 90° gegenüber den Sendepulsen des ersten Resonators verschoben ist. Man kann zeigen, dass dadurch ein räumliches Drehfeld entsteht, das sich viel effizienter zur Anregung des Spinsystems eignet als das normale, räumlich stationäre Feld. Zudem gewinnt man durch das Quadratur-Verfahren einen Faktor √2 an S/N-Verhältnis gegenüber dem gewöhnlichen Verfahren mit nur einem Resonator, weil das Rauschen der beiden Resonatoren nicht miteinander korreliert ist. Auch das maximale durch das Resonatorsystem erzeugte *B*₁-Anregungsfeld (Nutz-HF-Feld) erhöht sich um den Faktor √2. Dieses Verfahren ist besonders geeignet, um verlustbehaftete Messproben, z.B. Salzlösungen, mit einem hohem S/N-Verhältnis zu messen.

Unabhängig von dem Modus, in dem das Resonatorsystem betreiben wird, sollte das Resonatorsystem ein möglichst homogenes *B*₁-Feld erzeugen und die Möglichkeit erlauben, einen zweiten Resonator möglichst nahe bei der Messprobe anzubringen.

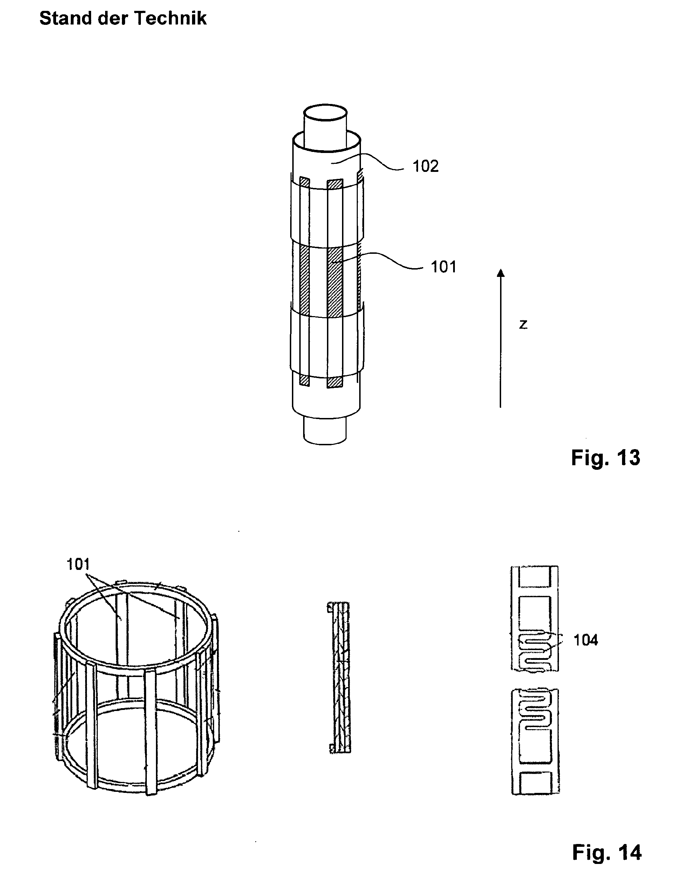

Aus Referenz [10] ist ein Hybrid- Birdcage-Resonator bekannt. Er ist aus massiven oder geschlitzten, optimal um die Messprobe herum angeordneten supraleitenden Leiterbahnen 101 aufgebaut, die parallel zur Achse der Messprobe liegen (siehe **Fig. 13**). Diese Leiterbahnen 101 sind ihrerseits kapazitiv über je ein normal leitendes rohrförmiges Element 102 an beiden Enden der Leiterbahnen 101 miteinander elektrisch verbunden. Da die Leiterbahnen 101 sehr nahe an der Messprobe angeordnet sind, und weil diese zudem praktisch rein induktiv wirken und keine kapazitive Funktion ausüben müssen, können sie den vollen kritischen Strom tragen. Beides zusammen führt dazu, dass das im Untersuchungsvolumen maximal erzeugbare *B*₁-Feld optimal groß und homogen wird. Dieser Resonator-Typ erreicht auch dementsprechend optimal kurze Pulsbreiten für einen gewünschten NMR-Flipwinkel. Die sehr kompakte Bauweise erlaubt insbesondere bei Messproben mit großen Durchmessern, wo der verbleibende Freiraum sehr begrenzt sein kann, optimale Einbaumöglichkeiten. Bei kleinen Durchmessern der Messprobe hingegen, führt der etwas kompliziertere Aufbau zu konstruktiven Grenzen. Derartige Resonatoren eignen sich insbesondere auch zum Betrieb im Quadratur-Modus und weisen eine gute Effizienz auf. Durch die Verwendung von normal leitendem Material für die rohrförmigen Elemente 102 ist die Güte jedoch relativ gering. Darüber hinaus ist der Aufbau von Hybrid-Birdcage-Resonatoren konstruktiv sehr anspruchsvoll.

Aus Referenz [11] ist ein quadraturtauglicher Birdcage-Resonator bekannt, der ausschließlich aus supraleitendem Material aufgebaut ist und dessen parallel zur Achse der Messprobe verlaufende Stangen 103 mäanderförmige Leiterstrukturen 104 enthalten (**Fig. 14**). Durch die Ausbildung des gesamten Resonators aus supraleitendem Material wird eine hohe Güte erreicht. Zusätzlich werden durch die Mäander-Struktur des Resonators jedoch unerwünschte elektrische Felder erzeugt, die einen negativen Einfluss auf die Verluste in leitfähigen Proben haben. Des Weiteren weist diese Anordnung auch eine sehr schlechte Feldhomogenität in z-Richtung auf, die das S/N-Verhältnis reduziert sowie eine sehr geringe Stromtragfähigkeit, so dass keine kurzen Pulswinkel realisiert werden können. Dies gilt auch für den Fall in dem die Mäanderstangen nicht selbstresonant betrieben werden sondern über den normal leitenden Ring noch kapazitiv verkoppelt werden.

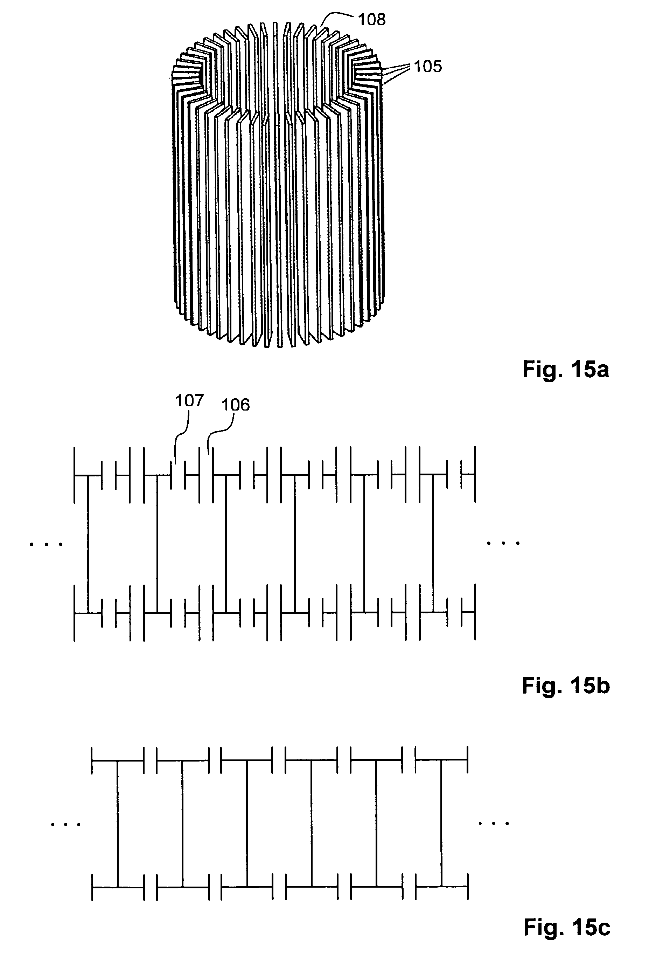

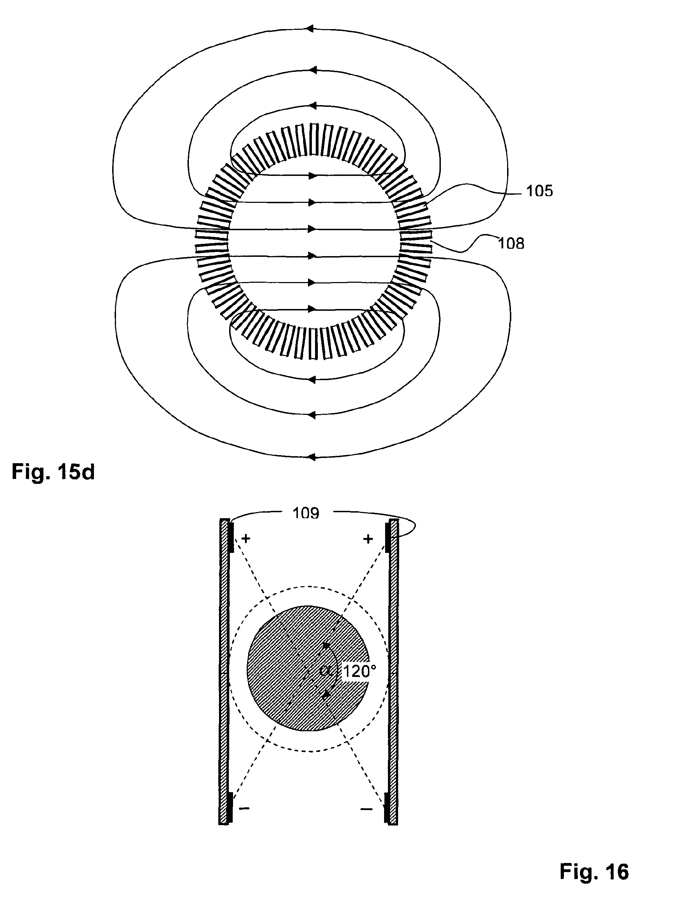

Referenz [11] offenbart darüber hinaus ein Resonatorsystem aus einer Vielzahl an Einzelresonatoren, 105 die um eine z-Achse radialsymmetrisch sternförmig angeordnet sind (**Fig. 15a**). Die Einzelresonatoren 105 bestehen jeweils aus zwei auf einem Substrat aufgebrachten parallelen HTS-Schichten, die eine Kapazität 106 bilden. Beim Zusammenbau werden die einzelnen Substratplatten so nah aneinander gebracht, dass sich eine weitere Kapazität 107 zwischen den HTS-Schichten benachbarter Einzelresonatoren 105 bildet. Um die zusätzlichen Kapazitäten 107 vernachlässigen zu können, so dass die Resonanzfrequenz allein durch die zwischen den Elektroden definierten Kapazitäten 106 gegeben wäre, müssten die Abstände im Mikrometerbereich liegen, was technisch nicht realisierbar ist. **Fig**. **15b** zeigt ein Ersatzschaltbild eines solchen Resonatorsystems. Der groß gezeichnete Kondensator repräsentiert die Kapazität 107 zwischen benachbarten Einzelresonatoren 105 und ist hierbei durch den Luft/Vakuumspalt 108 gegeben, der kleine Kondensator stellt die Kapazität 106 zwischen den Elektroden eines Substrats dar. Die Punkte in Fig. 15b bedeuten, dass noch mehr Stangen mit entsprechenden Kondensatoren an beiden Seiten angebaut sind. Des Weiteren ist die Struktur geschlossen, d.h. der linke Rand ist mit dem rechten Rand kapazitiv verbunden. Wird nun das Resonatorsystem zur Resonanz gebracht, dann kann der Strom durch die Kondensatoren an den Enden der Einzelresonatoren von einem Einzelresonator zum nächsten fließen, in den "Ringen" oben und unten ist der Strom quasi als Verschiebungsstrom in den Kondensatoren 106, 107 definiert. Werden die Kondensatoren 106,107 zusammengefasst ergibt sich ein Ersatzschaltbild wie in **Fig. 15c.** Dies ist nichts anderes als ein völlig normaler Hochpass-Birdcage Resonator. Die Feldverteilung in der xy-Ebene dieser Anordnung ist in **Fig. 15d** dargestellt.

Aus Referenzen [1] - [8] sind Helmholtz-Resonatoren bekannt, die aufgrund der exklusive Verwendung von HTS-Material eine sehr hohe Güte aufweisen. Bei geeigneter geometrischer Anordnung (Positionierung zweier Leiter 109 unter 120°, wie in **Fig. 16** gezeigt, kann mit dieser Anordnung eine relativ gute Feldhomogenität erreicht werden. Da die Strom tragenden Elemente weit von der Messprobe entfernt sind, ist die Effizienz jedoch gering. Zudem benötigen die bekannten Anordnungen viel Platz, wodurch Resonatoren für weitere Frequenzen deutlich weiter von der Probe entfernt sind, bzw. aus Platzgründen überhaupt nicht montiert werden können. Nachteilig ist auch, dass diese Vorrichtungen nur beschränkt quadraturtauglich sind, nämlich lediglich wenn die Leiter 109 unter weniger als 90° angeordnet werden.

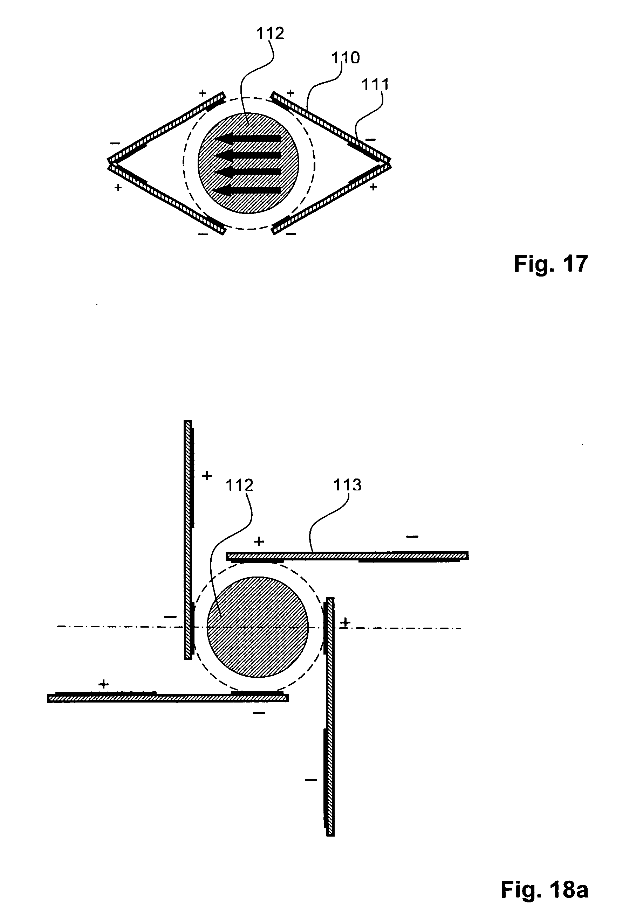

Referenz [9] offenbart "Twin-V" Resonatoren, die aus mehreren gleichen auf planaren dielektrischen Substraten 110 aufgebrachten Einzelresonatoren 111 zusammengesetzt sind, wie in **Fig. 17** gezeigt. Mit dieser Vorrichtung wird bei einem gegebenen Strom durch den Resonanzkreis ein optimal großes *B*₁-Feld im Zentrum des Untersuchungsvolumens 112 erzeugt, wobei die Richtung des *B*₁-Feldes annähernd parallel zur Ebene des Substrats 110 verläuft und die Parallelitätsabweichung maximal 40° betragen soll. Neben der hohen Güte und der guten Feldhomogenität der zuvor beschriebenen Resonatoren wird hier zusätzlich eine relativ gute Effizienz realisiert. Nachteilig an dieser Anordnung ist, dass sie nur für kleine Proben einsetzbar ist und ein hohes Streufeld erzeugt, so dass eine starke Kopplung mit weiteren Resonatoren die Folge ist. In der in Fig. 17 gezeigten Ausführungsform kann die Anordnung zudem nur in linear polarisierter Mode betreiben werden.

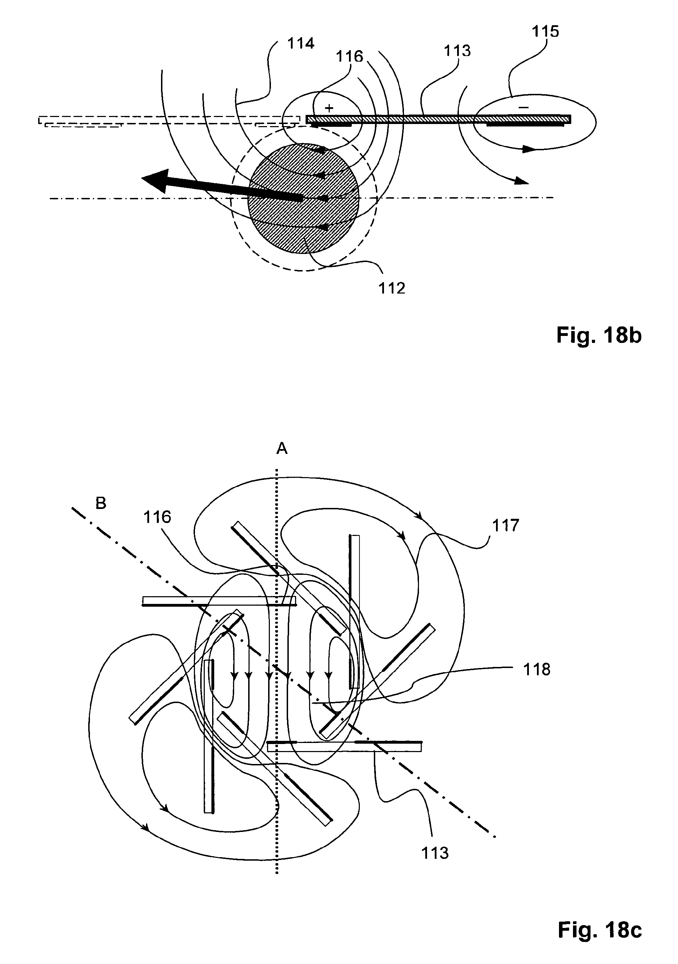

Des Weiteren ist aus Referenz [9] bekannt, dass Anordnungen mit mehreren Einzelresonatoren umfassenden Bauelementen 113 auch zur Erzeugung von räumlichen Drehfeldern benutzt werden können. Eine derartige Anordnung ist in **Fig. 18a** gezeigt. Die Bauelemente 113 sind windradförmig um eine Achse angeordnet. In **Fig. 18b** ist das durch einen Einzelresonator erzeugte Magnetfeld 114 (Einzel-HF-Feld) dargestellt. Daraus wird ersichtlich, dass lediglich ein Teil der Einzel-HF-Felder des Einzelresonators, in diesem Fall das durch den Strom (+) erzeugte Feld 114, zur Erzeugung des Nutz-HF-Feldes im Untersuchungsvolumen 112 genutzt wird, wohingegen das durch den Gegenstrom (-) erzeugte Feld 115 auf der anderen Seite des Einzelresonators möglichst weit von der Probe entfernt angeordnet ist, um nicht das Nutz-HF-Feld auszulöschen oder anderweitig unnötig zu beeinflussen. Die Effizienz der Drehfelderzeugung kann gesteigert werden, indem n Bauelemente 113 benutzt werden, die gemäß Fig.18a aufgebaut und symmetrisch um das Untersuchungsvolumen 112 herum angeordnet sind. Ein Bauelement 113 ist so angeordnet, dass der Leiter 116 senkrecht über dem Zentrum des Untersuchungsvolumens 112 liegt. Angefangen mit einem ersten Bauelement 113 werden n-1 weitere identische Bauelemente 113 hinzugefügt, wobei diese gegenüber dem ersten um 360°/n um die Längsachse des Untersuchungsvolumens 112 gedreht werden. Dabei entsteht ein rosettenartiges, symmetrisches Gebilde, mit dem ein Drehfeld angeregt werden kann. **Fig. 18c** zeigt eine derartige Anordnung mit acht auf Bauelementen 113 angeordneten Einzelresonatoren. Das Fern-HF-Feld solcher Resonatorsysteme mit der Symmetrieebene B ist gegenüber dem Nutz-HF-Feld mit der Symmetrieebene A verdreht und zwar um den Winkel 360°/n, d.h. in dem in Fig. 18c gezeigten Beispiel um 45°. Werden mehr Einzelresonatoren verwendet, dann wird der Winkel immer kleiner. Aus geometrischen Gründen ist für hochauflösende NMR-Spulen (wie in Referenz [9] erläutert), *n* > 8-10 kaum realisierbar, so dass der Winkel des Fernfeldes in jeder realisierbaren Situation mehr als 36° gegenüber dem Nutz-HF-Feld verdreht ist. Diese Verdrehung des Nutz-HF-Feldes gegenüber dem Fern-HF-Feld hat jedoch zur Folge, dass es mit derartigen Resonatorsystemen extrem schwierig ist, weitere Resonatoren für zusätzliche Frequenzen zu montieren und, insbesondere induktiv, so anzukoppeln, dass vernachlässigbare Kopplung zwischen dem Resonatorsystem und den weitern Resonatoren entsteht. Man beachte auch, dass im Inneren des Resonatorsystems ein Feld existiert (Einzel-HF-Feld), das deutlich höher ist als das Nutz-HF-Feld. Diese Ausführungsform benötigt noch mehr Platz als eine Anordnung mit Helmholzpaaren, so dass Resonatoren für weitere Frequenzen deutlich weiter vom Sample entfernt sind, bzw. aus Platzgründen überhaupt nicht montiert werden können.

Hieraus wird ersichtlich, dass alle Resonatortypen gemäß Stand der Technik einige zum Teil gravierende Nachteile haben.

Aufgabe der vorliegenden Erfindung ist es, das Resonatorsystem aus [9] derart weiterzubilden, dass trotz eines einfachen und kompakten Aufbaus, eine hohe Effizienz, volle Quadraturtauglichkeit und eine gute Feldhomogenität realisiert werden.

Diese Aufgabe wird erfindungsgemäß dadurch gelöst, dass ein Resonatorsystem vorgeschlagen wird, bei dem die erste Ebene A gegenüber der zweiten Ebene B nicht oder um weniger als 360°/(*N*+1) um die z-Achse verdreht ist.

Im optimalen Fall ist die erste Ebene A gegenüber der zweiten Ebene B gar nicht verdreht, so dass das Fern-HF-Feld in dieselbe Richtung wie das Nutz-HF-Feld zeigt beziehungsweise das Fern-HF-Feld um 180° gegenüber dem Nutz-HF-Feld verdreht ist. Eine Verdrehung der Ebene A gegenüber der Ebene B um weniger als 360°/(*N*+1) entspricht demnach einer Verdrehung des Fern-HF-Feldes gegenüber dem Nutz-HF-Feld um einen Winkel α, mit α<360°/(*N*+1) (Fall 1) beziehungsweise um einen Winkel α, mit180°<α<180°+360°/(*N*+1) (Fall 2). Beim ersten Fall des erfindungsgemäßen Resonatorsystems wird also der Winkel zwischen den Ebenen A und B bewusst kleiner als 360°/(*N*+1) gehalten, damit das Nutz-HF-Feld in der Größenordnung der Einzel-HF-Felder ist, was eine hohe Effizienz des Resonatorsystems zur Folge hat. Bei den Anordnungen des zweiten Falles, d.h. der Winkel zwischen den Ebenen A und B liegt zwischen 180° und 180°+360°/(*N*+1), sind die Einzel-HF-Felder zwar deutlich größer als das Nutz-HF-Feld, die Anordnungen bringen aber die Flexibilität zur aktiven Abschirmung des HF-Feldes nach außen.

In einer bevorzugten Ausführungsform der vorliegenden Erfindung enthalten die Einzelresonatoren supraleitendes Material. Dadurch wird eine hohe Güte erreicht.

In einer besonders bevorzugten Ausführungsform sind die Einzelresonatoren bis auf die dielektrischen Substrate und eine gegebenenfalls vorgesehene normal leitende metallische Quenchschutzschicht ausschließlich aus Supraleitermaterial aufgebaut. Dies ist besonders vorteilhaft, da bei der erfindungsgemäßen Vorrichtung hohe Ströme fließen und durch den Aufbau des Resonatorsystems die entstehenden Verluste minimiert werden können.

Eine Ausführungsform der Erfindung sieht vor, dass die Einzelresonatoren oder Gruppen von Einzelresonatoren in einer 2-zähligen Rotationssymmetrie um die z-Achse angeordnet sind. Diese Anordnung eignet sich besonders gut für den Betrieb des Resonatorsystems im linear polarisierten Modus.

Eine besonders einfache Anordnung ergibt sich, wenn die Anzahl der Einzelresonatoren N = 2(*i+*2) beträgt, wobei *i* eine natürliche Zahl ist.

Bei einer alternativen Ausführungsform des erfindungsgemäßen Resonatorsystems sind die Einzelresonatoren entsprechend ihrer Anzahl N in einer N-zähligen Rotationssymmetrie um die z-Achse angeordnet.

Eine Weiterbildung dieser Ausführungsform sieht vor, dass die Anzahl der Einzelresonatoren *N* = 4(*i*+1) beträgt, wobei i eine natürliche Zahl ist. Diese Anordnung begünstigt vor allem den Betrieb des Resonatorsystems im zirkular polarisierten Modus, da ein einfaches Ankoppeln unter 90° mit der entsprechenden Phasenverschiebung ermöglicht wird.

Bei einer vorteilhaften Ausführungsform des erfindungsgemäßen Resonatorsystems sind die Einzelresonatoren auf den Flächen eines Polyeders angeordnet. Die Einzelresonatoren können dann derart angeordnet sein, dass sich nach oben und nach unten fließende Ströme partiell auslöschen können, so dass die resultierende Stromverteilung durch die Differenzströme der Einzelresonatoren charakterisiert ist. Diese Anordnung benötigt den geringsten Platz von allen hier vorgestellten Anordnungen und ist technisch am einfachsten realisierbar.

Eine weitere Ausführungsform sieht vor, dass die Einzelresonatoren derart angeordnet sind, dass die Flächennormalen der Substrate eine tangentiale Komponente aufweisen. Die Einzelresonatoren können somit einander partiell Überlappen, so dass Leiter mit entgegen gesetzten Strömen hintereinander zu liegen kommen. Dies ist die effektivste Anordnung um Differenzströme auf möglichst geringem Raum zu bilden und führt zu einer besonders hohen Homogenität des Nutz-HF-Feldes.

Bei einer speziellen Ausführungsform des erfindungsgemäßen Resonatorsystems sind die Einzelresonatoren sternförmig radial nach außen angeordnet, so dass die Flächennormalen der Substrate tangential ausgerichtet sind. Bei dieser Anordnung steht der volle Umfang der zu messenden Probe für Strom führende Leiter zur Verfügung. Dadurch können besonders kurze Pulswinkel erreicht werden. Darüber hinaus eignet sich diese Anordnung zur aktiven Abschirmung der HF-Felder.

Als Einzelresonatoren können bei dem erfindungsgemäßen Resonatorsystem Spiralresonatoren und/oder Resonatoren mit verteilten Kapazitäten und/oder Resonatoren mit lokalisierten Kapazitäten und/oder doppelseitige Resonatoren vorgesehen sein. Die Wahl der Resonatorform ist dabei abhängig von der jeweiligen Anwendung.

Zur aktiven Abschirmung des erzeugten HF-Magnetfelds in z-Richtung ist es vorteilhaft, wenn mehrere Einzelresonatoren entlang der z-Richtung angeordnet sind. Somit kann eine Modellierung der Stromverteilung in z-Richtung vorgenommen werden.

Besonders vorteilhaft ist es, wenn zur aktiven Abschirmung des erzeugten HF-Magnetfelds in einer *xy*-Ebene senkrecht zur z-Richtung mehrere Einzelresonator(en) in radialer Richtung geschachtelt angeordnet sind, was bei einer sternförmigen Anordnung am einfachsten zu realisieren ist.

Eine besonders vorteilhafte Ausführungsform ergibt sich, wenn mehrere mit einem oder mehreren Einzelresonator(en) versehene Substrate in z-Richtung und/oder in radialer Richtung gestapelt beziehungsweise geschachtelt sind. Auf diese Weise lässt sich mit kleinen Substraten und entsprechend kleinen Einzelresonatoren ein vergleichsweise großes Resonatorsystem konstruieren.

Bei einer weiteren Ausführungsform des erfindungsgemäßen Resonatorsystems weist mindestens einer der Einzelresonatoren eine andere Resonanzfrequenz auf als die anderen Einzelresonatoren. Dadurch kann das Resonatorsystem so aufgebaut werden, dass es zwei linear polarisierte Moden mit unterschiedlichen Frequenzen aufweist, die zur Messung von zwei verschiedenen Kernen verwendet werden können.

Die Einzelresonatoren sind vorzugsweise induktiv und/oder kapazitiv und/oder galvanisch angekoppelt.

Ein vorteilhaftes Resonatorsystem ergibt sich, wenn es aus einer Kombination von zuvor beschriebenen Resonatorsystemen und bekannten normal leitenden und/oder supraleitenden Einzelresonatoren und/oder Resonatorsystemen besteht.

Die vorliegende Erfindung betrifft des Weiteren ein Verfahren zum Anpassen der Eigenresonanzen der Einzelresonatoren eines zuvor beschriebenen Resonatorsystems, umfassend folgende Schritte:
- a.: Auslegen eines beliebigen Resonatorsystems;
- b.: Berechnung der Strome *l*₀ die maximale Feldhomogenität im Untersuchungsvolumen bei gegebener geometrischer Anordnung der Einzelresonatoren erlaubt.
- c.: Berechnung der Stromverteilung im Resonatorsystem und des Magnetfeldes im Untersuchungsvolumen für die gewünschte Resonanz-Mode;
- d.: Rechnerische Bestimmung der durchschnittlichen Ströme in den Leiterelementen der Einzelresonatoren;
- e.: Korrektur der Eigenresonanzen der Einzelresonatoren, wobei diese Änderungen weitestgehend proportional zur jeweiligen Abweichung der Ströme von den Werten *l*₀ sein soll;
- f.: Wiederholen der Schritte b bis e solange, bis die Homogenität des Magnetfeldes im Untersuchungsvolumen maximal ist.

Weitere Vorteile der Erfindung ergeben sich aus der Beschreibung und der Zeichnung. Ebenso können die vorstehend genannten und die weiter aufgeführten Merkmale je für sich oder zu mehreren in beliebigen Kombinationen Verwendung finden. Die gezeigten und beschriebenen Ausführungsformen sind nicht als abschließende Aufzählung zu verstehen, sondern haben vielmehr beispielhaften Charakter für die Schilderung der Erfindung.

Es zeigen:
- Fig. 1 a-d: Schnittdarstellungen in der xy-Ebene von Geometrien für Resonatorsysteme gemäß der vorliegenden Erfindung mit N-zähliger Rotationssymmetrie;
- Fig. 2a-d: Schnittdarstellungen in der *xy*-Ebene von Geometrien für Resonatorsysteme gemäß der vorliegenden Erfindung mit 2-zähliger Rotationssymmetrie;
- Fig. 3: eine Schnittdarstellung in der *xy*-Ebene einer Geometrie für ein Resonatorsystem gemäß der vorliegenden Erfindung mit 2-zähliger Rotationssymmetrie und unterschiedlich großen Einzelresonatoren;
- Fig. 4a-f: Schnittdarstellungen in der *xy*-Ebene von Geometrien für Resonatorsysteme gemäß der vorliegenden Erfindung mit geschachtelten Einzelresonatoren;
- Fig. 5: eine schematische Darstellung der Stromrichtungen und des Magnetfelds in der xy-Ebene für ein Resonatorsystem mit einer Geometrie gemäß Fig. 1d;
- Fig. 6: eine Stromverteilung eines Resonatorsystems in einer Abwicklungsdarstellung;
- Fig. 7: eine schematische Darstellung des Fern-HF-Feldes und des Nutz-HF-Feldes für ein Resonatorsystem mit einer Geometrie gemäß Fig. 1 b;
- Fig. 8a: eine schematische Darstellung der Stromrichtungen und des Magnetfelds in der *xy*-Ebene für ein Resonatorsystem mit versetzten Einzelresonatoren;
- Fig. 8b: eine schematische Darstellung des Fern-HF-Feldes und des Nutz-HF-Feldes in der *xy*-Ebene für ein Resonatorsystem mit einer Geometrie gemäß Fig. 8a;
- Fig. 9a, b: Schnittdarstellungen in der *xy*-Ebene von Geometrien für Resonatorsysteme gemäß der vorliegenden Erfindung mit radial nach außen angerichteten Einzelresonatoren;
- Fig. 9c: eine schematische Darstellung des Fern-HF-Feldes und des Nutz-HF-Feldes in der *xy*-Ebene für ein Resonatorsystem mit radial nach außen gerichteten Einzelresonatoren;
- Fig. 9d: Ersatzschaltbild für ein Resonatorsystem nach Fig. 9a-c;
- Fig. 10a: einen Ausschnitt eines Resonatorsystems mit mehreren in z-Richtung hintereinander angeordneten Einzelresonatoren mit schematischer Darstellung der Strom- und Magnetfeldrichtungen;
- Fig. 10b: einen Ausschnitt eines Resonatorsystems mit mehreren in z-Richtung und in radialer Richtung hintereinander angeordneten Einzelresonatoren mit schematischer Darstellung der Magnetfeldrichtungen;
- Fig. 11: eine Abwicklungsdarstellung eines composit-Resonators bestehend aus mehreren in z-Richtung gestapelter Resonatorsysteme gemäß der vorliegenden Erfindung mit schematischer Darstellung der Magnetfeldrichtungen;
- Fig. 12a-d: Einzelresonatorformen gemäß dem Stand der Technik;
- Fig. 13: eine Hybrid-Birdcage-Spule gemäß dem Stand der Technik;
- Fig. 14: eine Birdcage-Spule mit Mäanderstreifen-Strukturen gemäß dem Stand der Technik;
- Fig. 15a: eine rein supraleitende Birdcage-Spule bestehend aus einer Vielzahl an Einzelresonatoren gemäß dem Stand der Technik;
- Fig. 15b, c: Ersatzschaltbilder für eine supraleitende Birdcage-Spule gemäß Fig. 15a;
- Fig. 15d: eine schematische Darstellung des Magnetfelds in der xy-Ebene für eine supraleitende Birdcage-Spule gemäß Fig. 15a ;
- Fig. 16: einen Helmholtz-Resonator gemäß dem Stand der Technik;
- Fig. 17: einen "Twin-V"-Resonator gemäß dem Stand der Technik;
- Fig. 18a: ein Resonatorsystem in einer verschobenen planparallelen Anordnung gemäß dem Stand der Technik;
- Fig. 18b: einen des Resonatorsystems gemäß Fig. 18a mit schematischer Darstellung des Magnetfeldes und der Stromrichtungen eines Einzelresonators in der *xy*-Ebene; und
- Fig. 18b: eine schematische Darstellung des Fern-HF-Felds und des Nutz-HF-Felds in der *xy*-Ebene eines Resonatorsystems gemäß Fig. 18a.

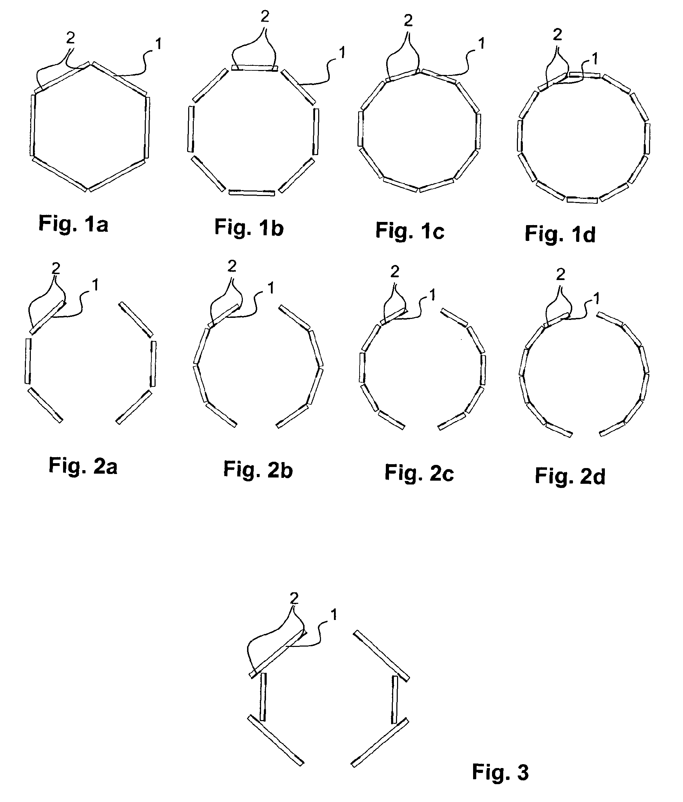

Fig. **1a-d** und **Fig. 2a-d** zeigen Schnitte verschiedener Ausführungsformen eines erfindungsgemäßen Resonatorsystems parallel zur *xy*-Ebene. Idealerweise werden N = 4(*i*+1) auf planaren Substraten 1 aufgebrachte Einzelresonatoren 2 (Fig. 1 b, d und Fig. 2b, d)) symmetrisch um ein Sample angeordnet. eine Anzahl von N = 2(*i*+2) Einzelresonatoren 2 ist jedoch für linear polarisierte Spulen durchaus auch sinnvoll.

Fig. 1 a-d zeigen Resonatorsysteme, bei denen die Einzelresonatoren 2 auf den Flächen eines Polyeders angeordnet sind. Die dargestellten Ausführungsformen weisen eine N-zählige Rotations- und Ebenensymmetrie auf und sind eher für zirkular polarisierte Spulen (Quadraturemission und -detektion) geeignet, wohingegen die in Fig. 2 aufgeführten Ausführungsformen lediglich eine 2-zählige Rotations- und Ebenensymmetrie zeigen und daher nur für linear polarisierte Spulen sinnvoll sind.

Die Einzelresonatoren 2 müssen nicht identisch groß sein, wie das Beispiel aus **Fig. 3** zeigt - allerdings macht es Sinn zumindest eine, besser aber beide Symmetrieebenen des Systems zu respektieren und daher alle Einzelresonatoren 2 in Paaren beziehungsweise Gruppen von vier auftauchen zu lassen.

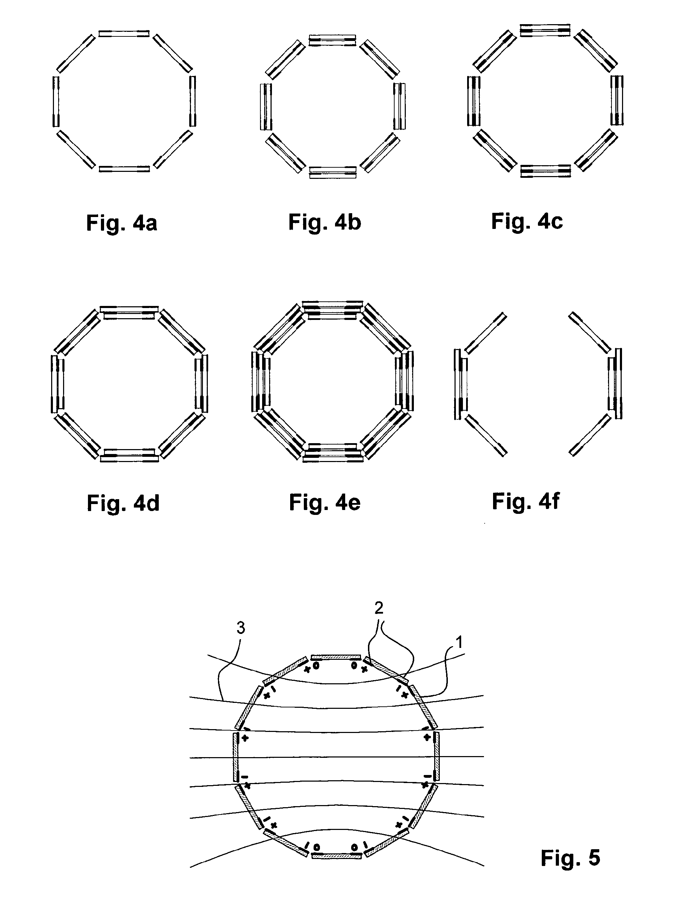

Um die Stromtragfähigkeit des Resonatorsystems zu erhöhen, kann man mehrere Einzelresonatoren 2 stapeln beziehungsweise schachteln, wobei bei linear polarisierten Resonatorsystemen (Fig. 2a-d, Fig.3) lediglich die "kritischen" verstärkt werden müssen. Dabei können entweder doppelseitig supraleitende Strukturen auf einem Substrat 1 aufgebracht **(Fig. 4a)** oder aber einseitig mit Einzelresonatoren 2 bestückte Substrate 1 gestapelt werden **(Fig.4b).** Darüber hinaus ist es auch möglich, doppelseitig mit Einzelresonatoren 2 bestückte Substrate 1 zu schachteln, wie in **Fig. 4c-f** dargestellt. Bei Verdopplung der Einzelresonatoren 2 sinkt die

Eigenfrequenz des Resonatorsystems um ca. √2. Dies kann auch dazu verwendet werden um eine tiefere Resonanzfrequenz zu erreichen als die Resonanzfrequenz, die mit einfachen Resonatorsystemen aufgrund deren geometrischer Begrenzungen möglich ist. Das Stapeln kann auch zum Trimmen der Resonator-systeme verwendet werden, indem Einzelresonatoren 2 mit leicht unterschiedlicher Resonanzfrequenz gestapelt werden.

In **Fig. 5** sind beispielhaft die Stromrichtungen (+: Strom fließt nach oben, -: Strom fließt nach unten) in den Leiterbahnen der Einzelresonatoren eines erfindungsgemäßen Resonatorsystems und einige Feldlinien 3 zu einem Zeitpunkt *t*₀ gezeigt. Ist das Feld des Resonatorystems linear polarisiert, dann wechseln über eine Phase hinweg die (+) Stromrichtungen mit den (-) Stromrichtungen durch die Resonatorschlaufen ab. Die beiden Einzelresonatoren 2, die senkrecht zum Magnetfeld stehen tragen nie Strom. Wird jedoch ein zirkular polarisiertes Feld ausgesandt, dann tragen alle Einzelresonatoren über eine Periode gesehen Strom. Zu den Zeitpunkten *t*_{*j*} = *t*₀ + (i π/6)/f kann die in Fig. 5 gezeigte Darstellung entsprechend jeweils um 30° gedreht werden. Sowohl der (+) Strom als auch der (-) Strom jedes Einzelresonators verlaufen möglichst nahe an der Probe, so dass beide Stromrichtungen zum Nutz-HF-Feld beitragen, wobei die beiden Resonatoren entgegengesetzte Felder erzeugen, die sich partiell auslöschen. Diese Auslöschung ist umso besser je geringer der Abstand der Strom führenden Leiter ist. Dieser sollte deutlich kleiner sein als der Abstand zur zu messenden Probe um hohe Feldhomogenität zu erreichen.

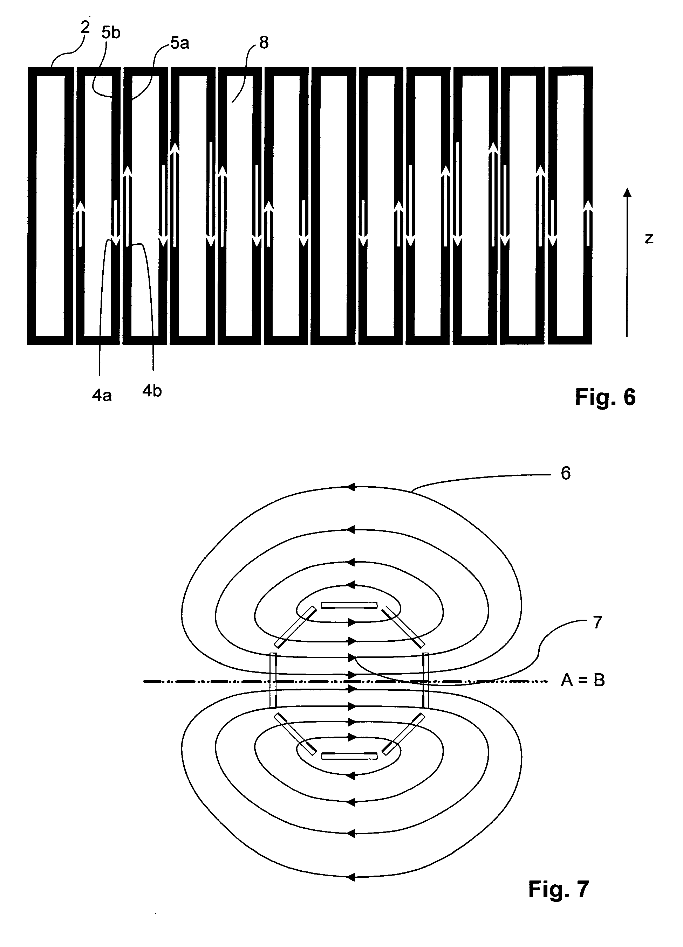

Die räumliche Stromverteilung des erfindungsgemäßen Resonatorsystems ist der Stromverteilung eines konventionellen Birdcage Resonators (BC) sehr ähnlich. Im Gegensatz zu einem konventionellen Birdcage Resonator, bei dem die einzelnen Stangen 103 jeweils einen bestimmten Strom tragen, wird dieser Strom bei den bis jetzt gezeigten erfindungsgemäßen Resonatorsystemen jedoch in zwei Ströme aufgeteilt: einen Strom 4a, der in (+) Richtung nach oben fließt und einen Strom 4b, der in (-) Richtung nach unten fließt. Bei dem erfindungsgemäßen Resonatorsystem werden die Knoten und Maschen nach den Kirchhoffschen Regeln so aufgeteilt, dass jede Masche separiert ist und keine Knoten mehr bestehen. **Fig. 6** zeigt schematisch die Einzelresonatoren 2 und die zugehörigen Ströme 4a, 4b zu einem Zeitpunkt t₀. Die z-Achse zeigt nach oben, im Anschluss an den rechten Einzelresonator folgt der linke (In der Darstellung ist der Umfang abgerollt). Insgesamt stellt sich durch die Differenzströme eine weitestgehend sinusoidale Stromverteilung über die Paare von Leiterabschnitten 5a, 5b der Einzelresonatoren 2 ein. Die Stromverteilung ist fast identisch mit der eines konventionellen BCs. Man erkennt sofort, dass im Prinzip viel zu viel Strom im Resonatorsystem fließt, der auf den ersten Blick unnötige Verluste erzeugt. Statt nur die Ströme in der Größenordnung der Differenzströme im Resonatorsystem zu haben, die in der Größenordnung von den Strömen eines konventionellen BCs liegen, fließen die Ströme 4a, 4b nach oben und unten, wobei sie jeweils deutlich höher sein können als der Differenzstrom (maximal ungefähr ein Viertel der Summe der Strömbeträge über alle Stangen eines konventionellen BCs)! Dies würde bei normal leitenden Einzelresonatoren zu sehr hohen Verlusten führen. Bei supraleitenden Einzelresonatoren, wie sie hier verwendet werden, sind die intrinsischen Güten jedoch so hoch, dass sowieso Maßnahmen getroffen werden müssen um die Güten auf für eine Magnetresonanzmessung "brauchbare" Werte zu drücken. Die zusätzlichen Verluste durch die sich teilweise kompensierenden Ströme sind daher irrelevant und fallen nicht ins Gewicht.

Wenn die Einzelresonatoren alle identisch sind, dann stellt sich durch die induktive Kopplung automatisch die gewünschte (sinusoidale) Stromverteilung ein. Will man, da man beispielsweise durch kritische Ströme limitiert ist, die Stromverteilung ändern, dann muss man lediglich die Resonanzfrequenzen der entsprechenden Einzelresonatoren 2 erhöhen (entweder durch Verringern der Induktivität L - kleinere Schlaufen oder der Kapazität C - weniger Überlappungen) beziehungsweise erniedrigen. Das erfindungsgemäße Resonatorsystem erlaubt daher auf einfache Art und Weise, bei linear polarisierten Spulen jede beliebige Verteilung der Ströme über die Einzelresonatoren einzustellen. Bei zirkularer Polarisation sollten aus Symmetriegründen stets alle Einzelresonatoren 2 identisch sein.

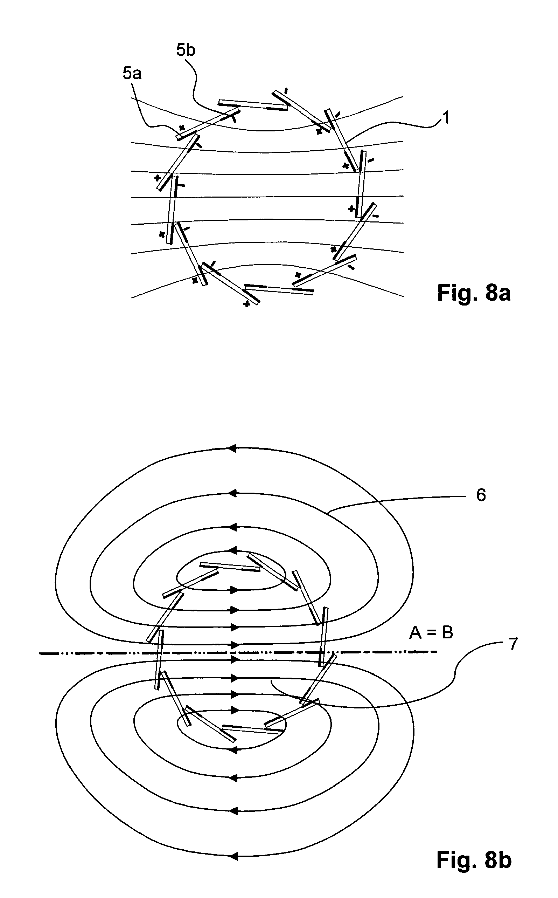

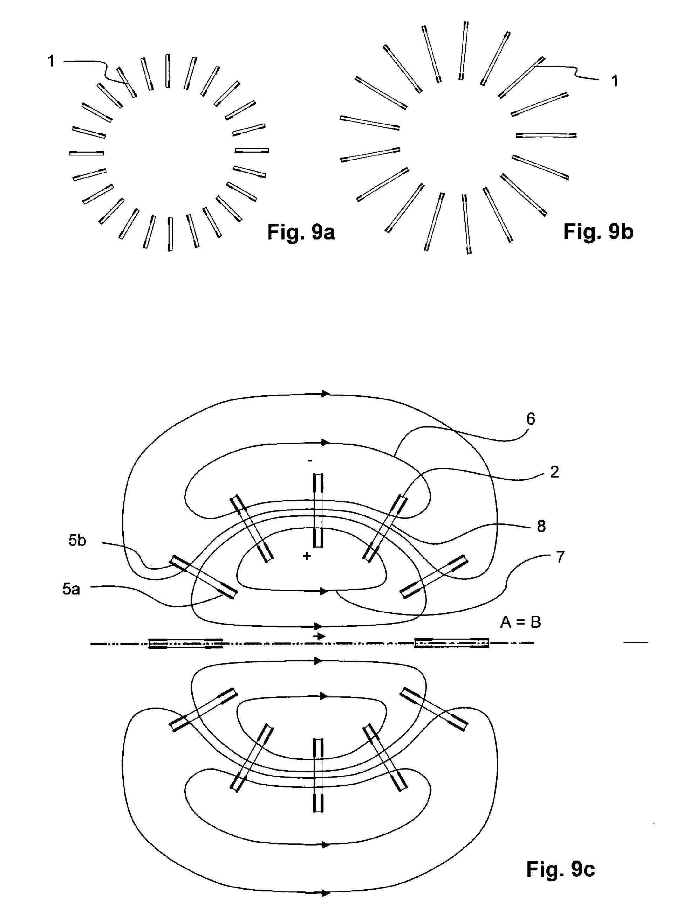

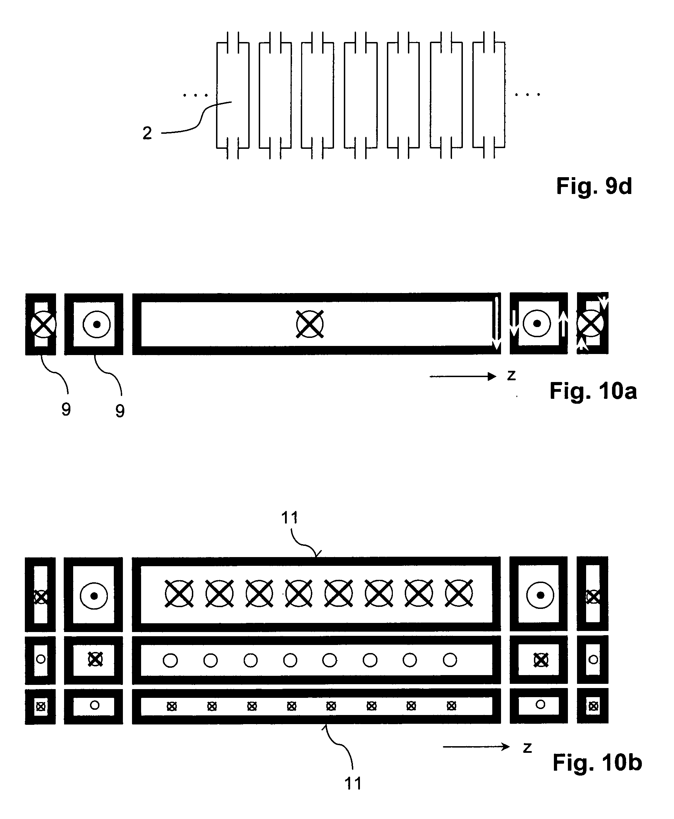

Es kann auch eine Spule mit Resonatoren unterschiedlicher Resonanzfrequenz so aufgebaut werden, dass das Resonatorsystem zwei orthogonale, linear polarisierte Moden mit unterschiedlichen Resonanzfrequenzen aufweist. Besonders geeignet sind hierzu Resonanzfrequenzen von Kernen, die möglichst nahe zusammen liegen, damit die Feldhomogenitäten der beiden Moden gut bleiben. Paare solcher Kerne sind z.B.¹H und ³H oder ¹H und ¹⁹F, ¹³C und ²³Na , ⁶³Cu oder ⁶⁵Cu etc. Für ein solches Resonatorsystem eignen sich insbesondere die Varianten der Erfindung vom Typ in Fig. 1 b, 1 d etc. aber auch vom Typ Fig. 8 oder 9.

Der grundlegende Unterschied zu allen aus der Literatur bekannten Birdcage-Resonatoren ist, dass das Resonatorsystem hier aus Einzelresonatoren aufgebaut ist, die einen "Kreisstrom" tragen, und keine rohrförmigen oder ringförmigen Elemente 102 existieren, die den Strom von einer Stange 103 des Resonators zu einer andern trägen, d.h. es gibt bei dem erfindungsgemäßen Resonatorsystem keine kapazitive Kopplung zwischen den Einzelresonatoren 2.

**Fig. 7** zeigt die Feldverteilung des Fern-HF-Feldes 6 und des Nutz-HF-Feldes 7 für ein Resonatorsystem mit einer Geometrie gemäß Fig. 1 b. Die räumliche Verteilung des Nutz-HF-Felds 7 zu einer ersten Ebene A, die die z-Achse enthält, und die des asymptotischen Fern-HF-Felds 6 zu einer zweiten Ebene B, die die z-Achse enthält, ist jeweils im Wesentlichen spiegelsymmetrisch. Das Nutz-HF-Feld 7 verläuft im Untersuchungsvolumen im Wesentlichen parallel zur ersten Ebene A. Man erkennt, dass die erste Ebene A mit der zweiten Ebene B zusammenfällt und das Nutz-HF-Feld in die Gegenrichtung des Fern-HF-Feldes verläuft. Das Nutz-HF-Feld ist also um 180° gegenüber dem Fern-HF-Feld verdreht. Der Aufbau eines MR-Probenkopfes mit weiteren Resonatoren für zusätzliche Frequenzen wird dadurch deutlich erleichtert. Ein zweites Resonatorsystem kann so angeordnet werden, dass es senkrecht auf dem ersten steht, wobei das innere Resonatorsystem nach wie vor auf einfache Art und Weise z.B. induktiv angekoppelt werden kann ohne nennenswerte Kopplung mit dem äußeren Resonatorsystem zu erzeugen. Dies ist nicht der Fall, wenn die Ebenen A und B gegeneinander verdreht sind

Bei den Ausführungsformen der Fig. 1, 4, 5 und 7 wurden die Einzelresonatoren 2 auf den Flächen von Polyedern angeordnet. Dies muss nicht zwingend so sein. Prinzipiell sind auch andere Geometrien sinnvoll. **Fig. 8a** beispielsweise zeigt eine Geometrie, bei der die Flächennormalen der Substrate 1 eine kleine tangentiale Komponente aufweisen. Die Substrate 1 sind hier überlappend angeordnet, so dass sich die Ströme 4a, 4b in Leiterabschnitten 5a, 5b, die "hintereinander" stehen, teilweise auslöschen und somit auch hier eine Differenzstrombildung stattfindet. Diese Ausführungsform stellt eine Möglichkeit dar, ein erfindungsgemäßes Resonatorsystem zu konstruieren, bei dem das Nutz-HF-Feld besonders homogen ist, da die Bildung von Differenzströmen auf geringst möglichem Raum stattfindet. **Fig. 8b** zeigt eine schematische Darstellung der zugehörigen Feldverteilung des Fern-HF-Feldes 6 und des Nutz-HF-Feldes 7 unter Vernachlässigung lokaler Feldverzerrungen in der Nähe der "Stangen" des Resonatorsystems. Man erkennt, dass auch hier, wie im Beispiel aus Fig. 7, die Ebenen A und B nicht gegeneinander verdreht sind. Das Prinzip bleibt damit dasselbe wie bei den zuvor beschriebenen Ausführungsformen. Die in Fig. 8b gezeigten Feldlinien vernachlässigen die lokale Feldverteilung in der Nähe der Strompfade. Die obigen Darstellungen sind solange gültig, wie die Strom führenden Leiter so nah beieinander sind, dass das Feld im Zwischenraum zwischen diesen nicht wesentlich größer ist als das Nutz-HF-Feld. Erst wenn das dieses Feld in derselben Größenordung wie das Nutz-HF-Feld ist beginnt sich das Fern-HF-Feld wesentlich gegenüber dem Nutz-HF-Feld zu verdrehen.

Der Unterschied zu dem aus dem Stand der Technik bekannten Resonatorsystem (Fig. 18a-c) ist, dass bei dem erfindungsgemäß Resonatorsystem die Ströme 4a in (+) Richtung und die Ströme 4b in (-) Richtung nahe beieinander verlaufen, so dass sie sich partiell auslöschen. Man lebt von den Differenzströmen, was bei den Resonatorsystemen aus dem Stand der Technik nicht der Fall ist. Während das Prinzip des in Fig. 18a abgebildeten Resonatorsystems darin besteht, die "störenden" Ströme, die bei dem erfindungsgemäß Resonatorsystem den Strömen 4b entsprechen, so weit wie möglich von der Probe zu entfernen, wird bei den bisher beschriebenen erfindungsgemäßen Resonatorsystemen die Differenzstrombildung ausgenutzt. Dies wird insbesondere bei Betrachtung der Feldverteilungen des Nutz-HF-Feldes 7 und des Fern-HF-Feldes 6 der beiden Resonatorsysteme deutlich. Während die Ebenen A und B bei dem aus dem Stand der Technik bekannten Resonatorsystems gegeneinander verdreht sind (Fig. 18c), fallen bei den in Fig. 7 und 8b gezeigten erfindungsgemäßen Resonatorsystemen die Ebenen A und B zusammen,.

Eine weitere Möglichkeit, ein erfindungsgemäßes Resonatorsystem zu konstruieren, ist in **Fig. 9a-c** gezeigt. Bei diesen sternförmigen Anordnungen löschen sich die Ströme 4a, 4b nicht aus. In Fig. 9c sind die Leiterabschnitte 5a, in denen die Ströme in (+)-Richtung fließen radial innen angeordnet, während die Leiterabschnitte 5b, in denen die Ströme in (-)-Richtung fließen hier nach außen gezogen sind. Das Feld, das im Zentrum des Resonatorsystems herrscht, wird im Außenbereich massiv durch die Einzelresonatoren 2 gequetscht. Allerdings sind die relevanten Ströme bei derartigen Anordnungen etwas weiter von der Probe entfernt und beanspruchen mehr Platz. Dafür kann die Stromtragfähigkeit dieses "sternförmigen" Resonatorsystems gegenüber einer Anordnung gemäß Fig. 1-8 durch Erhöhen der Anzahl von Einzelresonatoren 2 deutlich erhöht werden.

Auch wenn das erfindungsgemäße Resonatorsystem aus Fig. 9a, b der aus Referenz [11] bekannten, aus Einzelresonatoren 105 konstruierte Birdcage-Anordnung (Fig. 15a) auf den ersten Blick ähnelt, ist die Feldverteilung bei dem erfindungsgemäßen Resonatorsystem deutlich anders als bei den aus der Literatur bekannten. Fig. 9c zeigt die zugehörige Feldverteilung für das erfindungsgemäße Resonatorsystem mit Fern-HF-Feld 6 und des Nutz-HF-Feld 7. Bei den hier vorgestellten sternförmigen Anordnungen ist das Fern-HF-Feld 6 im Außenraum des Resonatorsystems in dieselbe Richtung gerichtet wie Nutz-HF-Feld 7 im Resonatorzentrum. Dies ist der aus [11] bekannten Birdcage-Anordnung genau umgekehrt (siehe Fig. 15d). Diese "Anomalie" kommt dadurch zustande, dass bei dem erfindungsgemäßen Resonatorsystem auf jedem Substrat 1 durch den Einzelresonator 2 ein vollständiger Ringstrom fließt. In Fig. 9c sind für einen Einzelresonator 2 die Stromrichtungen durch (+) und (-) markiert. Im Inneren des Resonatorsystems fließt ein Strom 4a nach oben (+), im Außenbereich des Resonatorsystems fließt ein Strom 4b herunter (-). Dadurch wird ein Feld durch die Fenster 8, den Zwischenraum der Einzelresonatoren 2, erzeugt. Im Gegensatz dazu fließen bei dem Resonatorsystem aus Fig. 15a keine Ringströme, so dass bei der in Fig. 15d gezeigte Feldverteilung, das Fern-HF-Feld entgegen dem Nutz-HF-Feld im Zentrum des Resonatorsystems verläuft.

Dies ist ein wesentlicher Unterschied des erfindungsgemäßen Resonatorsystems zu den bereits bekannten. Bei dem erfindungsgemäßen Resonatorsystem ist auf jedem Substrat 1 ein Einzelresonator 2 definiert, der im Betrieb im Wesentlichen dieselbe Stromverteilung aufweist wie beim Betrieb eines Einzelresonators 2 für sich - d.h. einen "Kreisstrom". Dabei bleibt auch die Resonanzfrequenz im Wesentlichen nahe bei der ursprünglichen Resonanzfrequenz. **Fig. 9d** zeigt das Ersatzschaltbild für die in Fig. 9a, b gezeigten sternförmigen Resonatorsysteme. Daraus wird ersichtlich, dass, im Gegensatz zu der bekannten Anordnung aus Fig. 15a mit den dazugehörigen Ersatzschaltbildern Fig. 15b, d, im Idealfall bei dem erfindungsgemäßen Resonatorsystem in Resonanz kein Strom von einem Einzelresonator 2 zum nächsten fließt. In Wirklichkeit gibt es natürlich noch vernachlässigbar kleine Streukapazitäten zwischen den Einzelresonatoren 2, die eventuell zu einem ganz geringen Stromübertrag von einem Einzelresonator 2 zum Nächsten sorgen. Diese sind aber bei allen praktischen Realisierungen allein durch die Unterschiede in den Dielektrizitätskonstanten der Materialien der Einzelresonatoren 2 (Saphir, Magnesiumoxyd oder Lanthanaluminat) zu der des Vakuums mindestens 50-mal kleiner als die Kapazitäten innerhalb der Einzelresonatoren 2.

Der Unterschied der Ausführungsform des erfindungsgemäßen Resonatorsystems nach Fig. 9a,b gegenüber dem bekannten Birdcage-Resonatorsystem wie in Fig. 15a gezeigt macht sich auch dadurch bemerkbar, dass die Moden nicht in der Folge eines gewöhnlichen High- oder Low-pass Birdcages bestehen, sondern in einer anderen Reihenfolge sortiert sind. D.h. es ist nicht "linear, quadrupol, oktupol, ..." bzw." ..., oktupol, quadrupol, linear" sondern "quadrupol, linear, oktupol".

Jede beschriebene Ausführungsform des erfindungsgemäßen Resonatorsystems, im Allgemeinen natürlich auch die mit auf Polyederflächen angeordneten Einzelresonatoren 2, können mit jeder beliebigen Zahl N von Einzelresonatoren 2, auch mit *N* ungerade, angefertigt werden, insbesondere wenn sie im Quadraturmode (mit zirkular statt linear polarisiertem Magnetfeld) betrieben werden.

Das Verfahren der Separierung der Kirchhoffschen Regeln gestattet es prinzipiell auch in z-Richtung eine beliebige Feldverteilung zu erzeugen. Durch Aufteilen des Raumes in viele kleine Schlaufen (Kompensationsspulen 9), wie in **Fig. 10a,** kann eine relativ genaue Modellierung der globalen Stromverteilung erreicht werden, die z.B. auch ein sehr steiles Abschneiden des Nutz-HF-Feldes 7 in z-Richtung erlaubt. Dies entspricht einer aktiven Abschirmung der Spule in z-Richtung.

Dasselbe Verfahren ist insbesondere bei Verwendung einer Anordnung wie in Fig. 9 auch in der *xy*-Ebene möglich, wenn auch sehr aufwendig zu realisieren. Man würde bei einer Anordnung wie z.B. in Fig. 7 oder 8a zusätzlich zum Hauptresonator viele Kompensationsspulen 9 in z-Richtung sowie radial anbringen. Dies ist schematisch in **Fig. 10b** beispielhaft für ein Resonatorsystem gemäß Fig. 9a, b gezeigt. Die obere Kante 10 des in Fig. 10b gezeigten Ausschnitts ist gegen das Zentrum des Resonatorsystems gerichtet, die untere Kante 11 steht nach außen. Die mit Punkten beziehungsweise Kreuzen gekennzeichneten Symbole zeigen die Richtung des durch das Resonatorsystem erzeugten Magnetfelds an. Prinzipiell kann eine vollständig aus Supraleiter aufgebaute Spule mit verschwindend geringem Streufeld gebaut werden. Dies stellt insbesondere eine sehr wirkungsvolle Methode dar um eine Quadraturspule mit weiteren Resonatorsystemen für zusätzliche Kerne zu versehen. Diese zusätzlichen Resonatoren können auch normal leitend sein ohne die Güte des inneren Resonatorsystems zu beeinflussen. Außerdem kann ein Gradientensystem das statische Feldgradienten in *x-,* y- und z-Richtung erzeugt ohne HF-Abschirmung montiert werden.

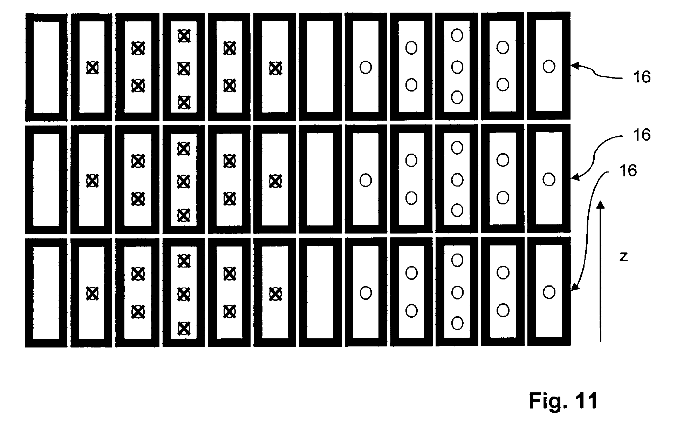

Dieses Prinzip der Kombination von Einzelresonatoren 2 erlaubt aber auch sehr große Resonatorsysteme als "composit-Resonatoren" unter Verwendung von relativ kleinen Substraten 1 aufzubauen (z.B. für MRI). **Fig. 11** zeigt eine Abwicklungsdarstellung eines "composit-Resonatorsystems", bestehend aus mehreren in z-Richtung gestapelt Resonatorsystemen 16 mit schematischer Darstellung der Magnetfeldrichtungen. Hierbei wurden in z-Richtung mehrere Resonatorsysteme 16 wie sie in Fig. 6 dargestellt sind, gestapelt, wodurch die effektive Größe des "composit-Resonatorsystems" beliebig anwachsen kann. Ist der Abstand zwischen den Leitern mit sich kompensierenden Strömen klein gegenüber dem Abstand zwischen den Leitern und der zu messenden Probe, so sind die resultierenden Feldstörungen vernachlässigbar. Auf diese Weise kann prinzipiell auch ein Birdcage für MRI-Messungen eines ganzen Körpers oder Kopfes vollständig aus HTS auf 2-3 Zoll Wafern aufgebaut werden.

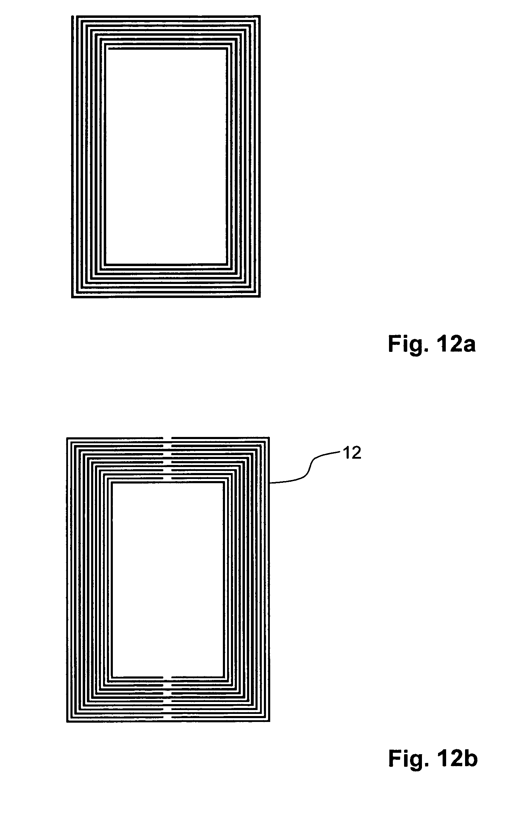

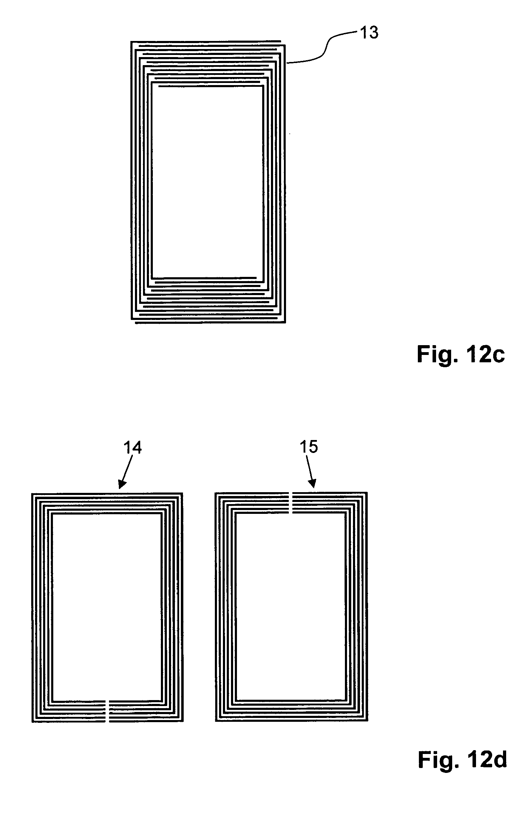

Als Einzelresonatoren können alle aus dem Stand der Technik bekannten Resonatoren zum Einsatz kommen. In **Fig. 12a-d** sind beispielhaft die gängigsten Geometrien dargestellt. Fig. 12a zeigt einen Spiralresonator, der besonders für tiefere Frequenzen geeignet ist. In Fig. 12b ist ein Resonator mit verteilten Kapazitäten dargestellt, der aus einer Vielzahl von Leiterelementen 12 zusammengesetzt ist. Bei einem Resonator mit lokalisierten Kapazitäten, wie in Fig. 12c gezeigt, sind U-förmiger Leiterelemente 13 ineinander geschachtelt mit nach außen hin gleichmäßig zunehmendem Überlappbereich. Eine Variante eines Resonators mit verteilten Kapazitäten ist eine Spule auf doppelseitig beschichtetem Substrat. Fig. 12d stellt Oberseite 14 und Unterseite 15 eines solchen beidseitig mit HTS-Material beschichteten Substrates dar.

Die Vorteile des erfindungsgemäß Resonatorsystems kommen besonders gut zur Geltung, wenn supraleitende Einzelresonatoren (z.B. aus YBCO) verwendet werden, da sonst die Verluste durch die ungefähr dreimal so hohen effektiven Ströme in den Leitern maßlos steigen würden. Aus supraleitendem Material hergestellte Einzelresonatoren sind für gewöhnlich mit einer normal leitende QuenchschutzSchicht ausgestattet. Diese Schicht ist in der Regel eine Edelmetallschicht (Ag, Au, ...) die vor der Strukturierung auf den Supraleiter aufgebracht wird. Sie dient zum einen als normal leitender Parallelpfad im Falle eines Quenchs, zum anderen kann durch Einstellen ihrer Leitfähigkeit (Dicke, Material, etc) die Güte des Resonators auf sinnvolle Werte um ca. 20-30000 eingestellt werden. Des Weiteren wird durch den hohen Reflexionskoeffizienten infrarote Strahlung reflektiert statt absorbiert.

Der Oberflächenwiderstand von YBCO ist bei den vorzugsweise verwendeten Frequenzen im Bereich 100 MHz - 1 GHz so gering, dass reine HTS-Resonatoren eine Güte von ca. ¹/₂Million haben. Dies ist für NMR viel zu hoch. Um vernünftige Anregungs- und Empfangsbreiten zu haben, können Güten über 20-30000 nicht sinnvoll eingesetzt werden. Eine "rein" aus Supraleiter hergestellte Spule wird daher auf diese Güten gedrückt, eine Hybridspule kann sie allerdings kaum erreichen. Ihre Werte liegen zwischen 6000-12000 - hauptsächlich durch die Leitfähigkeit des Normalleiters bestimmt.

Das hier vorgestellte Resonatorsystem kann folglich das Signal zu Rauschverhalten im Bezug auf eine Hybrid-BC Spule um ca. einen Faktor 1.5-2 verbessern (hauptsächlich durch Erhöhung der Güte). Dasselbe gilt auch in Bezug auf ein Helmholzpaar von planaren supraleitenden Resonatoren. Hier ist bei gleicher Güte die Effizienz um ca. einen Faktor 2-3 besser, wodurch um einen Faktor 1.5 besseres S/N resultiert.

Zusammenfassend kann festgestellt werden, dass durch den Aufbau des erfindungsgemäße Resonatorsystems mit auf ebenen Substraten aufgebrachten Einzelresonatoren, deren Einzel-HF-Feld durch ein Fenster des Einzelresonators verläuft, wobei die Symmetrieebenen des Fern-HF-Feldes und des Nutz-HF-Feldes nicht oder nur wenig gegeneinander verdreht sind, mit konstruktiv einfachen Mitteln ein Resonatorsystem mit einer verbesserten Feldhomogenität bei voller Quadraturtauglichkeit, hoher Güte und großer Effizienz realisiert werden kann. Darüber hinaus lässt sich mit dem erfindungsgemäßen Resonatorsystem eine nahezu beliebige räumliche Feldverteilung erreichen. Damit löst das hier vorgestellte Resonatorsystem alle bekannten Probleme von supraleitenden Magnetresonanzspulen.

### Literaturliste

[1] Wong et al. US 6590394 B2
[2] Withers US 6556013 B2
[3] Brey et al. US 5619140 A
[4] Brey et al. US 5594342 A
[5] Withers US 5585723 A
[6] Brey et al US 5565778 A
[7] Withers et al US 5351007 A
[8] Withers et al US5276398
[9] Marek US2002190715
[10] Marek US 6121776
[11] Wong et al. US 6377047

### Bezugszeichenliste

- 1: Substrat
- 2: Einzelresonator
- 3: Feldlinien
- 4a,b: Ströme in (+) beziehungsweise in (-) Richtung
- 5a,b: Leiterabschnitt
- 6: Fern-HF-Feld
- 7: Nutz-HF-Feld
- 8: Fenster
- 9: Kompensationsspulen
- 10: obere Kante
- 11: untere Kante
- 12: Leiterelemente
- 13: U-förmige Leiterelemente
- 14: Oberseite eines beschichteten Substrats
- 15: Unterseite eines beschichteten Substrats
- 101: Leiterbahn
- 102: rohrförmiges Element
- 103: Stangen
- 104: mäanderförmige Leiterstrukturen
- 105: Einzelresonatoren
- 106: Kapazität zwischen den Elektroden eines Einzelresonators
- 107: Kapazität zwischen zwei benachbarten Einzelresonatoren
- 108: Luft/Vakuumspalt
- 109: Leiter
- 110: Substrat
- 111: Einzelresonatoren
- 112: Untersuchungsvolumen
- 113: Bauelement
- 114: durch den Strom (+) erzeugte Feld
- 115: durch den Gegenstrom (-) erzeugte Feld
- 116: Leiter
- 117: Fern-HF-Feld
- 118: Nutz-HF-Feld

## Patentansprüche

1. Resonatorsystem zur Erzeugung eines Hochfrequenz (=HF)-Magnetfelds im Untersuchungsvolumen einer Magnetresonanz (=MR) Anordnung, das eine Anzahl N von Einzelresonatoren (2) umfasst, die das Untersuchungsvolumen umgeben und welche jeweils auf ebenen, dielektrischen Substraten (1) aufgebracht und um eine z-Achse angeordnet sind, wobei die Einzelresonatoren (2) Fenster (8) aufweisen, durch die hindurch im Einzelbetrieb der Einzelresonatoren (2) im Untersuchungsvolumen jeweils ein Einzel-HF-Feld und im Zusammenwirken der Einzelresonatoren (2) im Untersuchungsvolumen ein Nutz-HF-Feld (7) und weit außerhalb des Resonatorsystems asymptotisch ein Fern-HF-Feld (6) erzeugt werden, wobei die räumliche Verteilung des Nutz-HF-Felds (7) zu einer ersten Ebene A, die die z-Achse enthält, und die des asymptotischen Fern-HF-Felds (6) zu einer zweiten Ebene B, die die z-Achse enthält, jeweils im Wesentlichen spiegelsymmetrisch ist, und im Untersuchungsvolumen das Nutz-HF-Feld (7) im Wesentlichen parallel zur ersten Ebene A verläuft, wobei die Anzahl der Einzelresonatoren (2) *N >* 4 beträgt, und wobei im Betrieb des Resonatorsystems zu mindestens einem Zeitpunkt die Substratebene mindestens eines Einzelresonators (2) einen Winkel größer als 40° und mindestens eines weiteren Einzelresonators (2) einen Winkel kleiner als 40° mit der Richtung des Nutz-HF-Felds (7) im Untersuchungsvolumen einschließt,
**dadurch gekennzeichnet**,
die erste Ebene A gegenüber der zweiten Ebene B nicht oder um weniger als 360°/(*N*+1) um die z-Achse verdreht ist.

2. Resonatorsystem nach Anspruch 1, **dadurch gekennzeichnet, dass** die Einzelresonatoren (2) supraleitendes Material enthalten.

3. Resonatorsystem nach einem der vorhergehenden Ansprüche, **dadurch gekennzeichnet, dass** die Einzelresonatoren (2) oder Gruppen von Einzelresonatoren (2) in einer ihrer Anzahl N entsprechenden Rotationssymmetrie um die z-Achse angeordnet sind, vorzugsweise in einer 2- oder 4-zähligen Symmetrie.

4. Resonatorsystem nach einem der vorhergehenden Ansprüche, **dadurch gekennzeichnet, dass** die Einzelresonatoren (2) auf den Flächen eines Polyeders angeordnet sind oder dass die Einzelresonatoren (2) derart angeordnet sind, dass die Flächennormalen der Substrate (1) eine tangentiale Komponente aufweisen, oder dass die Einzelresonatoren (2) sternförmig radial nach außen angeordnet sind, so dass die Flächennormalen der Substrate (1) tangential ausgerichtet sind.

5. Resonatorsystem nach einem der vorhergehenden Ansprüche, **dadurch gekennzeichnet, dass** als Einzelresonatoren (2) Spiralresonatoren und/oder Resonatoren mit verteilten Kapazitäten und/oder Resonatoren mit lokalisierten Kapazitäten und/oder doppelseitige Resonatoren vorgesehen sind.

6. Resonatorsystem nach einem der vorhergehenden Ansprüche, **dadurch gekennzeichnet, dass** zur aktiven Abschirmung des erzeugten HF-Magnetfelds in z-Richtung mehrere Einzelresonatoren (2) entlang der z-Richtung angeordnet sind oder dass zur aktiven Abschirmung des erzeugten HF-Magnetfelds in einer *xy*-Ebene senkrecht zur z-Richtung mehrere Einzelresonatoren (2) in radialer Richtung geschachtelt angeordnet sind.

7. Resonatorsystem nach einem der vorhergehenden Ansprüche, **dadurch gekennzeichnet, dass** mehrere mit einem oder mehreren Einzelresonator(en) (2) versehene Substrate (1) in z-Richtung und/oder in radialer Richtung gestapelt beziehungsweise geschachtelt sind.

8. Resonatorsystem nach einem der vorhergehenden Ansprüche, **dadurch gekennzeichnet, dass** mindestens einer der Einzelresonatoren (2) eine andere Resonanzfrequenz aufweist als die anderen Einzelresonatoren, insbesondere dass das Resonatorsystem zwei linear polarisierte Moden mit unterschiedlichen Frequenzen aufweist.

9. Resonatorsystem nach einem der vorhergehenden Ansprüche, **dadurch gekennzeichnet, dass** die Einzelresonatoren (2) induktiv und/oder kapazitiv und/oder galvanisch angekoppelt sind.
